# EUROPEAN PATENT SPECIFICATION

(11) **EP 1 876 708 B1**
(45) Date of publication and mention of the grant of the patent: **10.09.2008**
(21) Application number: 06291118.5
(22) Date of filing: 06.07.2006
(51) Int. Cl.: H03J 3/00

(54) **Integrated tuner circuit with antenna control**
Integrierte Abstimmschaltung mit Antennenkontrolleinheit
Circuit d' accord intégré avec commande d'antenne

(43) Date of publication of application: 09.01.2008
(73) Proprietor: Dibcom, 91120 Palaiseau (FR)
(72) Inventor: Jönnson, Jonas, 17458 Sundbyberg (SE)
(74) Representative: Cefai, Robin

(56) References cited:
- WO-A-00/42585
- WO-A-20/05006579
- DE-A1- 4 332 798
- US-A- 4 862 516
- US-A- 5 349 700
- US-A- 6 133 834
- US-A1- 2003 119 469

## Description

The present invention relates to integrated tuner circuits with antenna control. Radio frequency transmissions generally require a large bandwidth. For example, the transmission range according to the DVB-H standard extends from about 470 MHz to 890 MHz. However, most commonly used antennas have a small bandwidth sensitivity of about 200 or 300 MHz.

To address this difference, two main approaches have been developed.

A first type of integrated tuner circuits uses several switched antennas, each with a different bandwidth sensitivity. For example, a first antenna is set for a range extending from 470 to 600 MHz and a second antenna is set for a range extending from 600 to 890 MHz. These tuners require specific additional components to control the antennas as well as internal and external components to ensure the switching between the antennas.

Another type of integrated tuner circuits uses external antenna resonance stages with capacitances resonating with the antenna to set the reception range by setting the frequency of maximum resonance. Such external antenna resonance stages usually use PIN diodes or varactor diodes and require an extra voltage supply.

None of these solutions is satisfactory as they both require many external components.

Document DE 43 32 798 describes an integrated circuit with an adaptable capacitance but is still unsatisfactory.

One advantage of the present invention is to solve these problems and provide an efficient integrated tuner circuit with antenna control with increased adaptation capacities.

To this effect, the invention recites an integrated tuner circuit according to claim 1. Thanks to the use of an internal resonance stage with a trimmable capacitance, this integrated tuner circuit has increased adaptation capacities.

Other features and advantages of the invention will be apparent from the description illustrated by the drawings in which:
- Figures 1A and 1B represent two uses of a first embodiment of the invention; and
- Figure 2 represents a second embodiment of the invention.

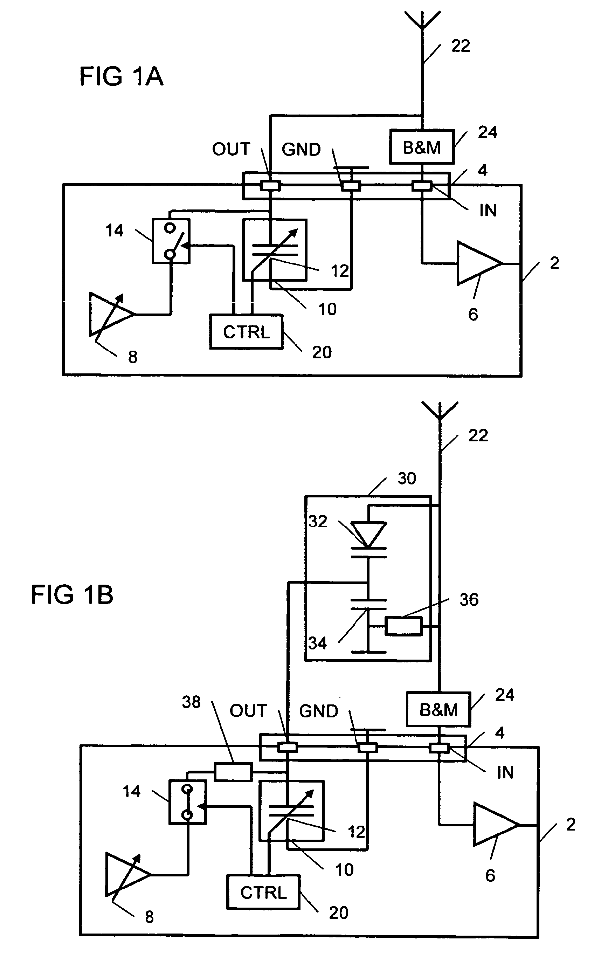

With reference to figures 1A and 1B, a first integrated tuner circuit 2 according to the invention will now be described. This integrated tuner circuit has an interface module 4 with inputs and outputs terminals, also called bond pads. In the example, the interface module 4 has at least one input terminal IN, one output terminal OUT and a ground terminal GND.

The integrated tuner circuit has an internal amplifier stage 6 connected to the input terminal IN and a voltage generator 8 connected to the output terminal OUT.

The integrated tuner circuit of the invention also comprises an internal resonance stage 10 connected to the output terminal OUT and to the ground terminal GND.

In the embodiment described, the internal resonance stage 10 comprises a trimmable capacitance 12 connected to the output terminal OUT and connected to a ground through the ground terminal.

Furthermore, the integrated tuner circuit 2 comprises a switch 14 connected between the voltage generator 8 and the output terminal OUT.

The integrated tuner circuit 2 also comprises a control module 20 adapted to digitally control the switch 14 and the value of the trimmable capacitance 12.

Besides these elements, the integrated tuner circuit comprises classical tuner components not represented.

Figure 1A represents a first use of this integrated tuner circuit in which an external antenna 22, such as a classical 50 ohms antenna, is connected to the input terminal IN and the output terminal OUT.

Advantageously, a balance and matching module 24, used to compensate for impedance imperfections of the antenna 22, is connected between the antenna 22 and the input terminal IN.

In this embodiment, the switch 14 disconnects the voltage generator 8 from the output terminal OUT, leaving connected only the trimmable capacitance of the internal resonance circuit 2.

Accordingly, the trimmable capacitance 12 is connected between the ground and the antenna 22 to achieve a L-C tank setting the maximum resonance value of the antenna and the reception range. Thus, the control of the value of the capacitance 12 by the control module 20, allows a digital setting of the reception range of the antenna 6.

In another use of the same integrated tuner circuit 2, represented with reference to figure 1B, an external resonance stage 30 is used.

This external resonance stage 30 is connected between the antenna 22, the output terminal OUT and the balance and matching module 24. To enable this external resonance circuit 30, the switch 14 connects the voltage generator 8 to the output terminal OUT.

More precisely, the external resonance stage 30 comprises a varactor diode 32 connected between the antenna 22 and a first terminal of a capacitance 34 in order to establish a voltage between the antenna and the output of the varactor diode. The second terminal of said capacitance 34 is connected to the ground. A first resistor 36 is connected between the balance and matching module 24 and the second terminal of the capacitance 34

The variations of voltage over this external resonance stage 30 change the range of maximal reception by changing the value for which the maximal resonance of the antenna 22 is reached. More precisely, the external resonance stage 30 and the antenna 22 create an L-C tank which resonance frequency is set by controlling the varactor diode 32.

The use of such an external resonance stage is classical and will not be described in more details.

In this embodiment, the resonance is set by both the external resonance stage 30 powered by the voltage generator 8 and the internal resonance stage 10.

Internal resistor 38 isolates the impedance of the external circuit 30 from the output impedance of the voltage generator 8 and the switch 14.

Thus, the integrated tuner circuit of the invention can be connected to an antenna, with or without an external resonance stage, with good adaptation capacities. The control of the internal trimmable capacitance allows tuning of the reception range of the antenna by changing its resonance value. The use of the internal switch 14 and the voltage generator allows to enable and to disable the external resonance stage and thus allows combining the tuner of the invention with existing circuitry including such an external resonance stage without any modification of this existing circuitry.

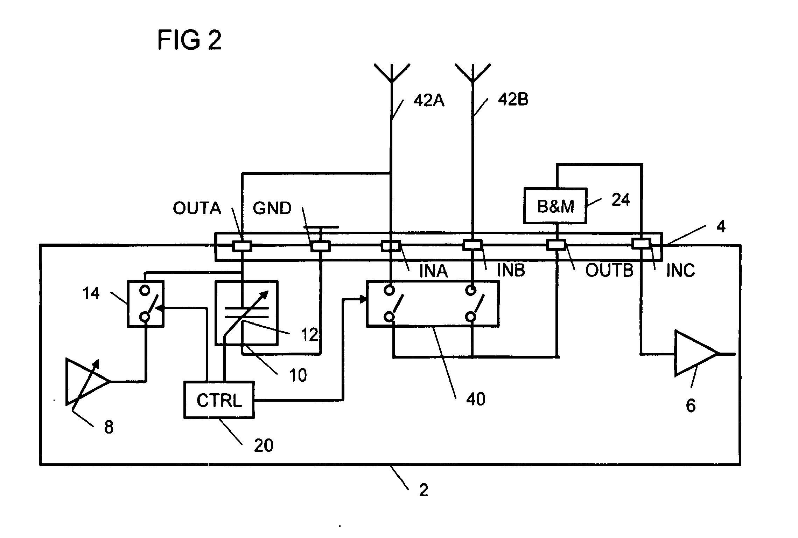

With reference to figure 2, another embodiment of the invention will now be described. In this embodiment, similar components are designed with the same references as in the previous embodiment.

In this example, the integrated tuner circuit 2 has three input terminals referenced INA, INB, INC and two output terminals OUTA and OUTB.

Each of the inputs INA and INB is connected to an internal switch stage 40 which is also connected to the output terminal OUTB, thus the switch stage 40 is able to connect the output terminal OUTB to one or the other of the input terminals INA and INB.

The integrated tuner circuit also comprises the elements described above, namely, the internal resonance stage 10, the control module 20, the amplification stage 6, the voltage generator 8 and the switch 14. In this embodiment, the amplification stage 6 is connected to the terminal INC and the control module 20 is also adapted to control the internal switch stage 40. Furthermore, the switch 14 to open to disable the voltage generator 8 and the terminal OUTA is directly connected to the terminal INA.

When used, this integrated tuner circuit is connected to two antennas 42A and 42B, each adapted to receive a specific range of the frequency spectrum.

More precisely, each of the inputs INA and INB is connected to a respective antenna 42A and 42B, thus, the antenna 42A is also connected to the internal resonance stage through the terminal OUTA.

The output terminal OUTB is connected to the balance and matching module 24 which output is fed to the amplification stage 6 through the terminal INC.

Depending upon the switch stage 40, the integrated tuner circuit 2 uses the antenna 42A or the antenna 42B directly.

Furthermore, due to the use of the internal switch 14, this tuner can be used with existing external resonance stages.

When the antenna 42A is used, the resonance value is set by the internal resonance stage 10 as described with reference to Figure 1A when the antenna 42B is used, the resonance value is set in a classical manner.

Thus, the integrated tuner circuit of the invention can be used to adjust the reception range of an antenna due to its internal trimmable capacitance. It can also be used with existing external resonance circuits and several antennas thanks to the internal switches.

Of course other embodiments are also possible.

Advantageously, the tuner comprises a unit monitoring the quality of the signal inputs and outputs. This monitoring unit provides the control module with quality information used to set the reception range by changing the value of the trimmable capacitance and/or selecting the antenna.

In another embodiment, the control unit receives configuration information to set the reception range.

Advantageously the trimmable capacitance is a specific capacitance such as a Metal Insulator Metal (MIM) capacitance to reduce the current loss between the antenna and the ground.

In one embodiment, the internal capacitance is digitally trimmed by use of several individual capacitances connected in parallel, each of them being series connected with a transistor used as a switch and digitally controlled. Accordingly, the digital control of the transistors allows the control of the overall value of the capacitance.

In another example, the integrated tuner circuit comprises only the internal antenna resonance stage and no voltage generator and thus, is not adapted to provide power to an external resonance stage.

In another embodiment, the matching and balance module is integrated in the tuner.

Still in another embodiment, when two antennas are used, each of them is connected to an internal resonance stage. If the same internal resonance stage is used, a switch connecting the internal resonance stage to one or the other of the antennas is added. Furthermore, each antenna can also be connected to an external resonance stage.

Other embodiments and combination of the ones described can also be achieved.

## Claims

1. Integrated tuner circuit (2) for radiofrequency signals suitable to be connected to at least one antenna (22; 42A, 42B) and to an external resonance stage (30), wherein the integrated tuner circuit comprises:
- an internal resonance stage (10) with at least one trimmable capacitance (12) adapted to be connected to the antenna and to resonate therewith;
- a control unit (20) adapted to control the value of said at least one trimmable capacitance to change the resonance value of the antenna; and
- a voltage generator (8) adapted to enable said external resonance stage.

2. Integrated tuner circuit according to claim 1, wherein said trimmable capacitance of said internal resonance stage is connected between a terminal (OUT; OUT A) of the integrated tuner circuit adapted to be connected to an antenna (22; 42A, 42B) and a terminal adapted to be connected to a ground (GND).

3. Integrated tuner circuit according to claim 1, further comprising an internal switch (14) to connect or disconnect said voltage generator (8) from said external resonance stage (30).

4. Integrated tuner circuit according to claim 3, wherein said trimmable capacitance (12) is connected to a terminal (OUT) of said integrated tuner circuit and said voltage generator (8) is connected to the same terminal of the integrated tuner circuit through said internal switch (14).

5. Integrated tuner circuit according to any one of claims 1 to 4, wherein said control unit (20) is adapted to receive configuration information and to control the value of the trimmable capacitance (12) depending upon said configuration information.

6. Integrated tuner circuit according to any one of claims 1 to 5, wherein said control unit (20) is adapted to receive quality information and to control the value of the trimmable capacitance (12) depending upon said quality information.

7. Integrated tuner circuit according to any one of claims 1 to 6, further adapted to be connected to several antennas (42A, 42B) and comprising an internal switch stage (40) to switch between said antennas, said internal resonance stage (10) being suitable to be connected to at least one of said antennas.

8. Integrated tuner circuit according to any one of claims 1 to 7, wherein said trimmable capacitance (12) is formed of several individual capacitances connected in parallel, each individual capacitance being series connected with a transistor functioning as a switch.

9. Integrated tuner circuit according to any one of claims 1 to 8, wherein said trimmable capacitance (12) comprises at least one Metal Insulator Metal capacitance.

## Patentansprüche

1. Integrierte Abstimmvorrichtungsschaltung (2) für Funkfrequenzsignale, die geeignet ist, mit zumindest einer Antenne (22; 42A; 42B) und einer externen Resonanzstufe (30) verbunden zu werden, wobei die integrierte Abstimmvorrichtungsschaltung umfasst:
- eine interne Resonanzstufe (10) mit zumindest einer abstimmbaren Kapazität (12), die angepasst ist, mit der Antenne verbunden zu werden und mit dieser zu schwingen;
- eine Steuereinheit (20), die angepasst ist, den Wert der zumindest einen abstimmbaren Kapazität zu steuern, um den Resonanzwert der Antenne zu ändern; und
- einen Spannungsgenerator (8), der angepasst ist, die externe Resonanzstufe einzuschalten.

2. Integrierte Abstimmvorrichtungsschaltung nach Anspruch 1, wobei die abstimmbare Kapazität der internen Resonanzstufe zwischen einem Anschluss (OUT; OUT A) der integrierten Schaltung, der angepasst ist, mit einer Antenne (22, 42A, 42B) verbunden zu werden und einem Anschluss verbunden ist, der angepasst ist, mit einer Erde verbunden zu werden.

3. Integrierte Abstimmvorrichtungsschaltung nach Anspruch 1, weiter mit einem internen Schalter (14), um den Spannungsgenerator (8) zu verbinden oder von der externen Resonanzstufe (30) zu trennen.

4. Integrierte Abstimmvorrichtungsschaltung nach Anspruch 3, wobei die abstimmbare Kapazität (12) mit einem Anschluss (OUT) der integrierten Abstimmvorrichtungsschaltung verbunden ist und der Spannungsgenerator (8) mit dem gleichen Anschluss der Abstimmvorrichtungsschaltung über den internen Schalter (14) verbunden ist.

5. Integrierte Abstimmvorrichtungsschaltung nach einem der Ansprüche 1 bis 4, wobei die Steuereinheit (20) angepasst ist, Konfigurationsinformation zu empfangen und den Wert der abstimmbaren Kapazität (12) in Abhängigkeit von der Konfigurationsinformation zu steuern.

6. Integrierte Abstimmvorrichtungsschaltung nach einem der Ansprüche 1 bis 5, wobei die Steuereinheit (20) angepasst ist, Qualitätsinformation zu empfangen und den Wert der abstimmbaren Kapazität (12) in Abhängigkeit von der Qualitätsinformation zu steuern.

7. Integrierte Abstimmvorrichtungsschaltung nach einem der Ansprüche 1 bis 6, weiter angepasst, mit mehreren Antennen (42A, 42B) verbunden zu werden und mit einer internen Schaltstufe (40), um zwischen den Antennen zu schalten, wobei die interne Resonanzstufe (10) geeignet ist, mit zumindest einer der Antennen verbunden zu werden.

8. Integrierte Abstimmvorrichtungsschaltung nach einem der Ansprüche 1 bis 7, wobei die abstimmbare Kapazität (12) aus mehreren einzelnen Kapazitäten gebildet wird, die parallel verbunden sind, wobei jede einzelne Kapazität mit einem Transistor serien-verbunden ist, der als Schalter funktioniert.

9. Integrierte Abstimmvorrichtungsschaltung nach einem der Ansprüche 1 bis 8, wobei die abstimmbare Kapazität (12) zumindest Metall-Isolator-Metall-Kapazität umfasst.

## Revendications

1. Circuit d'accord intégré (2) pour des signaux de radiofréquence convenant pour être connecté à au moins une antenne (22 ; 42A, 42B) et à un étage extérieur de résonance (30), dans lequel le circuit d'accord intégré comprend :
- un étage intérieur de résonance (10) avec au moins une capacité réglable (12) adaptée pour être connectée à l'antenne et pour résonner avec elle ;
- une unité de commande (20) adaptée pour commander la valeur de ladite au moins une capacité réglable pour changer la valeur de résonance de l'antenne ; et
- un générateur de tension (8) adapté pour activer ledit étage extérieur de résonance.

2. Circuit d'accord intégré selon la revendication 1, dans lequel ladite capacité réglable dudit étage intérieur de résonance est connectée entre une borne (OUT ; OUT A) du circuit d'accord intégré adaptée pour être connectée à une antenne (22 ; 42A, 42B) et une borne adaptée pour être connectée à une masse (GND).

3. Circuit d'accord intégré selon la revendication 1, comprenant en outre un commutateur interne (14) destiné à connecter ou déconnecter ledit générateur de tension (8) dudit étage extérieur de résonance (30).

4. Circuit d'accord intégré selon la revendication 3, dans lequel ladite capacité réglable (12) est connectée à une borne (OUT) dudit circuit d'accord intégré et ledit générateur de tension (8) est connecté à la même borne dudit circuit d'accord intégré par l'intermédiaire dudit commutateur interne (14).

5. Circuit d'accord intégré selon l'une quelconque des revendications 1 à 4, dans lequel ladite unité de commande (20) est adaptée pour recevoir des informations de configuration et pour commander la valeur de la capacité réglable (12) en fonction desdites informations de configuration.

6. Circuit d'accord intégré selon l'une quelconque des revendications 1 à 5, dans lequel ladite unité de commande (20) est adaptée pour recevoir des informations de qualité et pour commander la valeur de la capacité réglable (12) en fonction desdites informations de qualité.

7. Circuit d'accord intégré selon l'une quelconque des revendications 1 à 6, adapté en outre pour être connecté à plusieurs antennes (42A, 42B) et comprenant un étage de commutateur interne (40) pour assurer une connexion entre lesdites antennes, ledit étage intérieur de résonance (10) étant adapté pour être connecté à au moins l'une desdites antennes.

8. Circuit d'accord intégré selon l'une quelconque des revendications 1 à 7, dans lequel ladite capacité réglable (12) est constituée de plusieurs capacités individuelles connectées en parallèle, chaque capacité individuelle étant connectée en série avec un transistor fonctionnant comme un commutateur.

9. Circuit d'accord intégré selon l'une quelconque des revendications 1 à 8, dans lequel ladite capacité réglable (12) comprend au moins une capacité métal-isolant-métal.
